# EUROPÄISCHE PATENTSCHRIFT

(11) **EP 1 869 738 B1**
(45) Veröffentlichungstag und Bekanntmachung des Hinweises auf die Patenterteilung: **02.11.2011**
(21) Anmeldenummer: 06722639.9
(22) Anmeldetag: 17.03.2006
(51) Int. Cl.: H01T 4/06, H05K 3/30

(54) **ÜBERSPANNUNGSABLEITER**
SURGE ARRESTER
DISPOSITIF DE PROTECTION CONTRE LA SURTENSION

(30) Priorität: 12.04.2005 DE 102005016848
(43) Veröffentlichungstag der Anmeldung: 26.12.2007
(73) Patentinhaber: EPCOS AG, 81669 München (DE)
(72) Erfinder: BOY, Jürgen, 13465 Berlin (DE); WERNER, Frank, 13591 Berlin (DE)
(74) Vertreter: Epping - Hermann - Fischer
(86) Internationale Anmeldenummer: PCT/DE2006/000483
(87) Internationale Veröffentlichungsnummer: WO 2006/108374

(56) Entgegenhaltungen:
- DE-A1- 10 253 166
- DE-C1- 10 059 534
- US-A- 4 851 946

## Beschreibung

Ein Drei-Elektroden-Überspannungsableiter mit aufschnappbaren Kontaktelementen ist aus der Druckschrift DE 10253166 A1 bekannt. Ein Drei-Elektroden-Überspannungsableiter mit einer abgeflachten Elektrode ist aus der Druckschrift DE 10059534 C1 bekannt. In der US 4,851,946 wird ein Überspannungsableiter gezeigt, der einen Aufsatz umfasst, welcher auf Elektroden aufgeschnappt ist.

Eine zu lösende Aufgabe besteht darin, durch einfache Maßnahmen das Wegrollen eines Überspannungsableiters bei dessen Montage zu verhindern.

Es wird ein Überspannungsableiter angegeben, umfassend einen vorzugsweise zylindrischen Grundkörper und eine darauf aufgeschnappte Klammer, die zwei Federbügel aufweist. Die Federbügel weisen mindestens zwei Stützbereiche auf, die in einer und derselben Ebene liegen. Diese Ebene kann z. B. außerhalb des Grundkörpers angeordnet sein. Alternativ kann die Unterseite des Grundkörpers in dieser Ebene liegen.

Somit kann das Wegrollen des Grundkörpers verhindert und somit eine Montage des Überspannungsableiters z. B. auf einer Platine erleichtert werden. Der beschriebene Überspannungsableiter ist aus diesem Grund insbesondere zur Oberflächenmontage geeignet.

Nachstehend werden bevorzugte Ausführungsformen des Überspannungsableiters erläutert.

Der Ableiter ist vorzugsweise ein gasgefüllter Überspannungsableiter.

Als Material für die Klammer kommen alle Materialien, vorzugsweise Metalle in Betracht, die zur Ausbildung von Federelementen geeignet sind. Die Klammer kann aber auch aus einem elektrisch isolierenden Material gefertigt sein.

Die Federbügel berühren einander gegenüberliegende Seiten der Mantelfläche und üben auf diese eine Federkraft aus.

Ein als Drei-Elektroden-Ableiter ausgeführter Überspannungsableiter weist eine vorzugsweise ringförmige Mittelelektrode und zwei auf Stirnseiten des Grundkörpers angeordneten endständigen Elektroden.

In einer bevorzugten Variante liegen die Stützbereiche in einer gemeinsamen Ebene, die außerhalb des Grundkörpers angeordnet ist. Dabei schneidet eine gedachte Linie, welche im Querschnitt quer zur Mantelfläche die untersten Punkte von Stützbereichen der beiden Federbügel miteinander verbindet, den Grundkörper nicht. Diese Linie kann jedoch in einer Variante mindestens einen Bereich an der Unterseite des Grundkörpers berühren, wobei dieser Bereich für den Ableiter als ein zusätzlicher Stützbereich dienen kann.

Die endständigen Elektroden können einen größeren Durchmesser als der Grundkörper aufweisen, wobei ihre nach unten gewandten Flächen vorzugsweise in derselben Ebene liegen wie die Stützbereiche. Somit sind in einer Variante sowohl die Stützbereiche als auch die endständigen Elektroden gegen eine gemeinsame Unterlage abstützbar.

In einer vorteilhaften Variante weisen die Federbügel jeweils einen Schlitz auf. Die Mittelelektrode kann vorzugsweise über den Rand des Ableiters überstehend ausgebildet werden und so in diesen Schlitz eingreifen. Der Federbügel wird so durch die Mittelelektrode geführt. Vorzugsweise ist die Breite des Schlitzes in Bezug auf die Breite der Mittelelektrode so bemessen, dass die Mittelelektrode in dem Schlitz befestigt werden kann.

Die Klammer weist vorzugsweise ein die Federbügel miteinander verbindendes Mittelstück mit einer ebenen Oberfläche auf. Das Mittelstück bietet somit eine Ansaugfläche, was bei einer SMD-Montage des Ableiters von Vorteil ist.

Die Klammer ist zwar fest mit dem Grundkörper verbunden. Aber sie muss dabei nicht notwendigerweise den Grundkörper in jedem Punkt berühren. Beispielsweise können pro Federbügel zumindest zwei Berührungsflächen vorgesehen sein, in denen die Klammer den Grundkörper berührt.

Die Federbügel sind vorzugsweise aufgespreizt, damit der Abstand zwischen Stützbereichen vergrößert und die Stabilität der Lage des Ableiters auf der Unterlage erhöht wird.

Die Klammer ist vorzugsweise quer zur Längsrichtung (Zylinderachse) des Grundkörpers angeordnet, wobei die Klammer den Grundkörper entlang seines Umfangs umfasst, und wobei die Federbügel auf die Mantelfläche des Grundkörpers drücken. Die Klammer kann aber auch in Längsrichtung des Grundkörpers ausgerichtet sein, so dass die Federbügel auf beide Stirnseiten des Grundkörpers drücken. Wesentlich ist, dass beide Federbügel dabei nach unten hin zumindest bis zur Unterseite des Grundkörpers oder darüber hinaus heruntergezogen sind.

Im folgenden wird der Ableiter anhand schematischer und nicht maßstabsgetreuen Figuren erläutert. Es zeigen schematisch:
Figur 1A eine erste Seitenansicht einer Klammer;
Figur 1B eine zweite Seitenansicht der Klammer gemäß Figur 1A;
Figur 1C eine Ansicht der Klammer gemäß Figur 1A in einem gestreckten Zustand;
Figur 2A eine erste Seitenansicht des Ableiters mit einem Grundkörper und der auf diesem aufgeschnappten Klammer gemäß Figur 1A;
Figur 2B eine zweite Seitenansicht der gemäß Figur 2A;
Figur 2C eine Ansicht der Baugruppe gemäß Figur 2A von oben;
Figur 3 eine Leiterplatte mit einer zur Kontaktierung des Ableiters geeigneten Auslegung von Kontaktflächen.

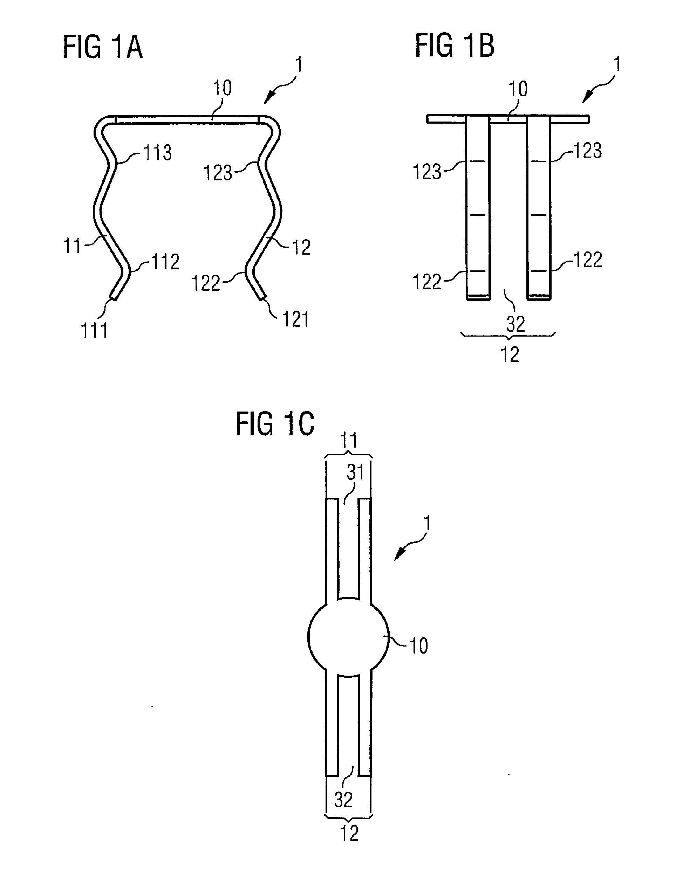

In Figuren 1A, 1B und 1C sind verschiedene Ansichten einer Klammer 1 mit einem Mittelstück 10 und zwei daran befestigten Federbügeln 11, 12 gezeigt. Die Klammer 1 ist dabei vorzugsweise einstückig ausgebildet.

Das Mittelstück 10 weist nach oben hin eine ebene Oberfläche auf.

Die Federbügel 11, 12 üben auf einander gegenüber liegende Seiten der Mantelfläche eine Federkraft aus.

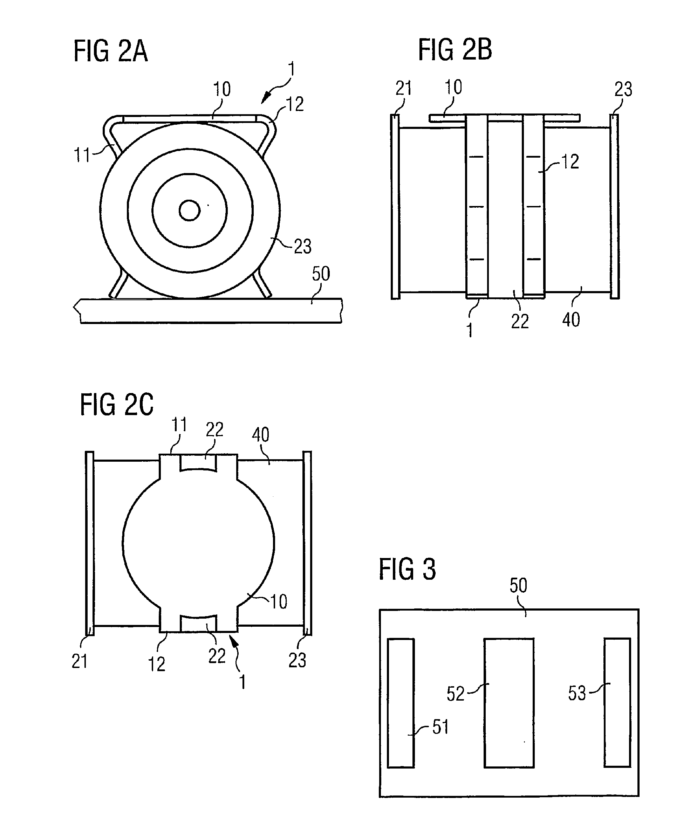

Die Federbügel 11, 12 weisen jeweils nach unten gewandte Stützbereiche 111, 121 auf, die nach unten hin aufgespreizt sind. Die Stützbereiche sind nach unten gewandt und beide gleichzeitig gegen eine Unterlage 50 abstützbar. Die Federbügel 11, 12 sind darüber hinaus derart mehrfach gebogen, dass sie jeweils zwei zum Grundkörper 40 des Ableiters gewandte Berührungsflächen 112, 113 bzw. 122, 123 aufweisen (Fig. 2A). Damit gelingt es, die Kontaktfläche zwischen dem Grundkörper und der Klammer zu minimieren.

Die Federbügel 11, 12 weisen jeweils einen Schlitz 31 bzw. 32 auf, dessen Breite an die Breite einer ringförmigen Mittelelektrode 22 des Ableiters angepasst ist.

In Figuren 2A, 2B und 2C sind verschiedene Ansichten einer Baugruppe gezeigt, welche einen Ableiter mit einem zylindrischen Grundkörper 10 und die darauf aufgeschnappte Klammer 1 umfasst.

An Stirnflächen des Grundkörpers 40 sind endständige Elektroden 21, 23 angeordnet, die einen größeren Durchmesser als der Grundkörper 40 aufweisen. Die Mittelelektrode 22 weist auch einen größeren Durchmesser als der Grundkörper 40.

Vorzugsweise sind die Stützbereiche 111, 121 der Federbügel sowie die nach unten gewandten Bereiche der Elektroden 21, 22, 23 alle in einer Ebene angeordnet.

Der in Figuren 2A bis 2C gezeigte Ableiter mit der Klammer ist zur Oberflächenmontage auf einer Unterlage 50 geeignet. Die Klammer 1 kann nach der Montage im Prinzip entfernt werden.

In Figur 3 ist eine mögliche Auslegung von Kontaktflächen 51, 52, 53 einer Leiterplatte gezeigt, welche für die beschriebene Baugruppe als eine Unterlage 50 dient. Die Kontaktfläche 52 wird mit der Mittelelektrode 22 verlötet. Die Kontaktflächen 51 und 53 werden jeweils mit einer endständigen Elektrode 21 bzw. 23 verlötet.

### Bezugszeichenliste

1 Klammer
10 Mittelstück der Klammer 1
11, 12 Federbügel
111, 121 Stützbereiche der Federbügel
112, 113 Berührungsflächen
122, 123 Berührungsflächen zwischen Federbügel und Grundkörper
21, 23 endständige Elektroden
22 Mittelelektrode
31, 32 Schlitz
40 Grundkörper
50 Unterlage
51, 52, 53 Kontaktflächen

## Patentansprüche

1. Überspannungsableiter, umfassend
- einen Grundkörper (40) mit einer Mantelfläche,
- eine Klammer (1), die auf dem Grundkörper (40) aufgeschnappt ist und zwei Federbügel (11, 12) aufweist,
- wobei die Federbügel (11, 12) wenigstens zwei Stützbereiche (111, 121) aufweisen, die in einer Ebene liegen,
**dadurch gekennzeichnet, dass** die Stützbereiche (111, 121) in einer gemeinsamen Ebene liegen, die außerhalb des Grundkörpers angeordnet ist oder dass eine Unterseite des Grundkörpers (40) in dieser Ebene liegt.

2. Überspannungsableiter nach Anspruch 1,
mit einer Mittelelektrode (22) und zwei auf Stirnseiten des Grundkörpers (40) angeordneten endständigen Elektroden (21, 23).

3. Überspannungsableiter nach Anspruch 2,
wobei die endständigen Elektroden (21, 23) einen größeren Durchmesser als der Grundkörper (40) aufweisen.

4. Überspannungsableiter nach Anspruch 2 oder 3,
wobei die Federbügel (11, 12) jeweils einen Schlitz (31, 32) aufweisen, dessen Breite im Wesentlichen gleich der Breite der Mittelelektrode (22) ist.

5. Überspannungsableiter nach einem der Ansprüche 1 bis 4, wobei die Klammer (1) ein die Federbügel (11, 12) miteinander verbindendes Mittelstück (10) mit einer ebenen Oberfläche aufweist.

6. Überspannungsableiter nach einem der Ansprüche 1 bis 5, wobei jeder Federbügel (11, 12) zumindest zwei Berührungsflächen aufweist, in denen der Grundkörper (40) berührt wird.

7. Überspannungsableiter nach einem der Ansprüche 1 bis 6, wobei die Federbügel (11, 12) aufgespreizt sind.

8. Überspannungsableiter nach einem der Ansprüche 1 bis 7, wobei der Grundkörper (40) zylindrisch ist.

9. Überspannungsableiter nach einem der Ansprüche 1 bis 8,
wobei die Stützbereiche (111, 121) beide gleichzeitig gegen eine Unterlage (50) abstützbar sind.

## Claims

1. Surge arrester, comprising
- a basic body (40) with a lateral surface,
- a clamp (1), which has been snapped onto the basic body (40) and has two spring clips (11, 12),
- the spring clips (11, 12) having at least two supporting regions (111, 121), which lie in one plane, **characterized in that** the supporting regions (111, 121) lie in a common plane, which is arranged outside the basic body or **in that** a lower side of the basic body (40) lies in this plane.

2. Surge arrester according to Claim 1, with a central electrode (22) and two end electrodes (21, 23) arranged on end sides of the basic body (40).

3. Surge arrester according to Claim 2, the end electrodes (21, 23) having a greater diameter than the basic body (40).

4. Surge arrester according to Claim 2 or 3, the spring clips (11, 12) each having a slot (31, 32), whose width is substantially equal to the width of the central electrode (22).

5. Surge arrester according to one of Claims 1 to 4, the clamp (1) having a central piece (10) with a planar surface, said central piece connecting the spring clips (11, 12) to one another.

6. Surge arrester according to one of Claims 1 to 5, each spring clip (11, 12) having at least two touching faces, at which touching contact is made with the basic body (40).

7. Surge arrester according to one of Claims 1 to 6, the spring clips (11, 12) being spread open.

8. Surge arrester according to one of Claims 1 to 7, the basic body (40) being cylindrical.

9. Surge arrester according to one of Claims 1 to 8, it being possible for the supporting regions (111, 121) to both be supported at the same time against a base (50).

## Revendications

1. Parasurtenseur comprenant
- un corps de base (40) muni d'une surface d'enveloppe,
- une pince (1) qui est enclipsée sur le corps de base (40) et qui présente deux étriers flexibles (11, 12),
- les étriers flexibles (11, 12) présentant au moins deux zones d'appui (111, 121) qui se trouvent dans un plan,
**caractérisé en ce que** les zones d'appui (111, 121) se trouvent dans un plan commun qui est disposé à l'extérieur du corps de base ou **en ce qu'**un côté inférieur du corps de base (40) se trouve dans ce plan.

2. Parasurtenseur selon la revendication 1, comprenant une électrode centrale (22) et deux électrodes terminales (21, 23) disposées sur les côtés frontaux du corps de base (40).

3. Parasurtenseur selon la revendication 2, dans lequel les électrodes terminales (21, 23) présentent un diamètre supérieur à celui du corps de base (40).

4. Parasurtenseur selon la revendication 2 ou 3, dans lequel les étriers flexibles (11, 12) présentent respectivement une fente (31, 32) dont la largeur est pour l'essentiel égale à la largeur de l'électrode centrale (22).

5. Parasurtenseur selon l'une des revendications 1 à 4, dans lequel la pince (1) présente une pièce centrale (10) ayant une surface plane qui relie les étriers flexibles (11, 12) entre eux.

6. Parasurtenseur selon l'une des revendications 1 à 5, dans lequel chaque étrier flexible (11, 12) présente au moins deux surfaces de contact dans lesquelles un contact est établi avec le corps de base (40).

7. Parasurtenseur selon l'une des revendications 1 à 6, dans lequel les étriers flexibles (11, 12) sont écartés.

8. Parasurtenseur selon l'une des revendications 1 à 7, dans lequel le corps de base (40) est cylindrique.

9. Parasurtenseur selon l'une des revendications 1 à 8, dans lequel les zones d'appui (111, 121) peuvent toutes deux prendre appui simultanément contre un support (50).
